Europäisches Patentamt

European Patent Office

Office européen des brevets

(11) Publication number: **0 191 478 B1**

# EUROPEAN PATENT SPECIFICATION

(45) Date of publication of patent specification: **13.05.92**  (51) Int. Cl.⁵: **H03M  1/10**

(21) Application number: **86101785.3**

(22) Date of filing: **13.02.86**

---

(54) **Measurement circuit for evaluating a digital-to-analog converter.**

---

(30) Priority: **14.02.85 JP 26730/85**

(43) Date of publication of application:
**20.08.86 Bulletin  86/34**

(45) Publication of the grant of the patent:
**13.05.92 Bulletin  92/20**

(84) Designated Contracting States:
**DE FR GB IT NL**

(56) References cited:

**1983 INTERNATIONAL TEST CONFERENCE,
18th-20th October 1983, pages 578-588, IEEE,
New York, US; J. HALBERT et al.: "A
waveform digitizer for dynamic testing of
high speed data conversion components"**

**EDN MAGAZINE, no. 13, 24th June 1981,
pages 189-192, Boston, Massachusetts, US;
R.A. PEASE: "Exerciser tests n-bit DACs for
8 words"**

(73) Proprietor: **Hewlett-Packard Company
Mail Stop 20 B-O, 3000 Hanover Street
Palo Alto, California 94304(US)**

(72) Inventor: **Tamamura, Toshio
1540-332, Kawaguchi-cho
Hachioji-shi Tokyo 193(JP)**

(74) Representative: **Schoppe, Fritz, Dipl.-Ing.
Seitnerstrasse 42
W-8023 Pullach bei München(DE)**

---

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.08/2.19/2.0)

EP 0 191 478 B1

## Description

The present invention relates to a circuit for measuring the characteristics of a digital to analog converter (DAC) in accordance with the prior art portion of claim 1.

A DAC, in general, produces analog output signals in response to digital input words. The output signal of the DAC must be in accurate correspondence to the input digital word. Accordingly an evaluation of the DAC characteristics is of great importance during the DAC development process, during manufacturing and before any use of a DAC (DAC's are available as individual components in the market today). A measurement for DAC evaluation can be performed by providing digital data words to a DAC in a DC environment and then measuring its output signals with a digital voltmeter to obtain its dynamic characteristics. Such dynamic measurement for DAC evaluation in the prior art typically has been carried out with two methods which are now described.

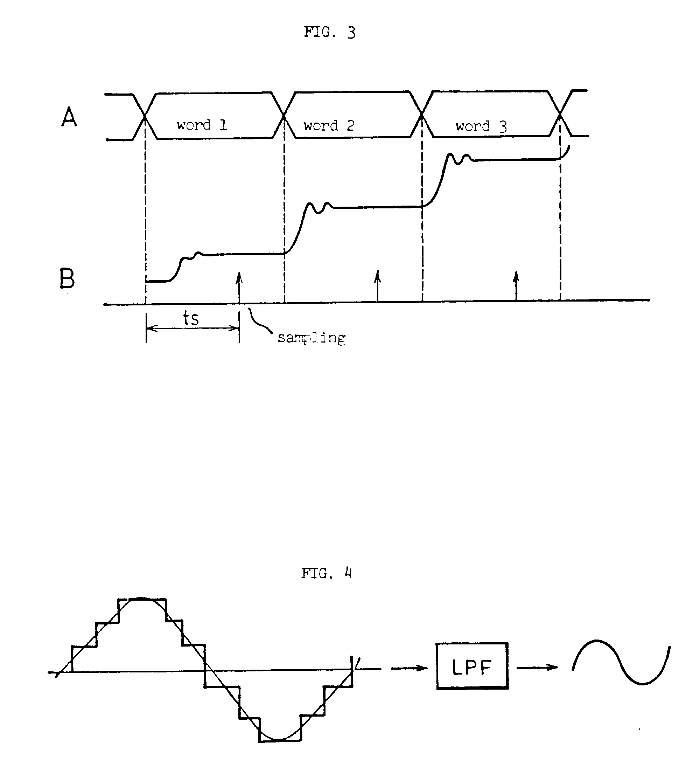

A circuit of the above-mentioned type for measuring the characteristics of a digital to analog converter is previously known in the art and is represented in Figure 3.

'A' represents input data words and 'B' represents the output analog signal of DAC. A delay time ts between the generation of the input word and the stabilization of the output analog signal is supplied to a sampler device and the analog output signal at each sampling point is sampled and converted to a digital value by an analog-to-digital converter (ADC) running at the same conversion rate as the DAC. The delay time ts can be shifted 1 ns by 1 ns, for example, by using a programmable delay line so that a number of different points of the output analog signal would be sampled. However, this has some inevitable disadvantages: 1) Since the sampling must be done with a high rate of conversion which must be comparable to the conversion rate of the DAC, a high-quality and expensive ADC and sample-and-hold circuit are necessary to attain a sufficiently accurate measurement during high-speed operation; 2) a programmable delay line must be used for generating the sampling delay time ts. The accuracy and resolution of the delay time ts thus entirely depends on the efficiency of the programmable delay line. It is quite difficult to change a delay time ts accurately in steps of 1 ns by 1 ns, for example, by programmable delay lines; 3) Although the delay time ts must be changed to adapt to various kinds of DAC for evaluation, there is a limitation by the range and resolution of the programmable delay line and ts cannot be prescribed simply and independently.

Fig. 4 shows another method for DAC measurement of the prior art. In order to obtain the output signal of the DAC as a pseudo-sine wave, corresponding digital words are provided to the DAC while the DAC operates at a high rate of conversion. The output signal is then converted to a sine wave by a low pass filter (LPF). An evaluation of the DAC may be made by analyzing the output analog sine wave. That is, any noise and distortion present in the analog signal can be measured. This method has the following disadvantages: 1) If a distortion appears in the output analog signal, it may be impossible to find the amplitude of the step wave output from the DAC and/or in the time of output from the DAC or in the time of generation of the output signal obtained. 2) The failure of the DAC may be suppressed by passing through the LPF so that proper evaluation of the DAC with its true charactristics cannot always be assured.

A further circuit for measuring the dynamic characteristics of a digital to analog converter is known from the publication 1983 INTERNATIONAL TEST CONFERENCE, 18th-20th October 1983, pages 578 to 588, IEEE, New York, US; J. HALBERT et al.: "A waveform digitizer for dynamic testing of high speed data conversion components". This prior art circuit comprises a test signal generator, the output of which is connected to the digital to analog converter forming the device under test and to a digitally programmable delay line. The output of the programmable delay line is connected to a sampling circuit in the form of a latching comparator having a integrator feedback loop for averaging the sampled values. The integrator output is fed to an analog to digital converter. Both the digitally programmable delay line and the analog to digital converter are controlled by a control computer. Thus, this prior art circuit suffers from the same drawbacks which have been evaluated with reference to Figure 3.

Another test circuit for testing digital to analog converters is known from EDN MAGAZINE, No. 13, 24th June 1981, pages 189-192, Boston, Massachusetts, US; R.A. PEASE: "Exerciser tests n-bit DACs for 8 words". This prior art test circuit comprises a counter circuit for generating eight successive addresses for selecting switches of a switch bank. These switches select the bits of the words, which get latched into respective flip-flops which in turn are connected to the digital to analog converter under test. The clock input of the digital to analog converter is fed to a clock-delay line formed by serially connected inverters. The delayed clock is fed to the flip-flops. Thus, this reference merely deals with the generation of a sequence of input bit-combination words for testing the DAC without disclosing details as to how the dynamic output characteristics of the DAC can be measured or analyzed.

Starting from the above-evaluated prior art, the present invention is based on the object of providing a circuit for measuring characteristics of a digital to analog converter of the above-mentioned kind which does not require a programmable delay line.

This object is achieved by a circuit in accordance with the prior art portion of claim 1 having the features indicated in the characterising portion thereof.

The significance of the claimed features is as follows. There is provided a clock generator for generating clock pulses, a word generator for generating digital input words for the DAC under clock control, a sampling unit for performing a delayed sampling of the analog DAC output signal under clock control, with a fixed delay time, and a pulse swallower interconnected between the clock generator and the word generator for selectably swallowing a number of clock pulses, thus to introduce a permanent time shift between the application of digital input words to the DAC and the sampling of the analog DAC output signal. Thus a digital input word may be selected, by selection of the number of pulses to be swallowed, for application to the DAC for subsequent sampling of the corresponding DAC output signal to occur.

Thus the relative shifting of sample points at the output analog signal of the DAC is done by delaying the DAC input words while the delay time of the sampling remains constant. Such delayed operation of the DAC input is achieved by using the pulse swallower to eliminate one or more clock pulses from a stream of clock signals from a clock generator so as to delay the time of generation of the next input word to the DAC.

An embodiment of the invention will now be described with reference to the accompanying drawings.

Fig. 1 is a block diagram of a measurement circuit for DAC evaluation.

Fig. 2 illustrates the operation of the circuit of Fig. 1.

Fig. 3 shows the input and output characteristics of a DAC in a measurement circuit of the prior art.

Fig. 4 shows another measurement circuit for DAC evaluation of the prior art.

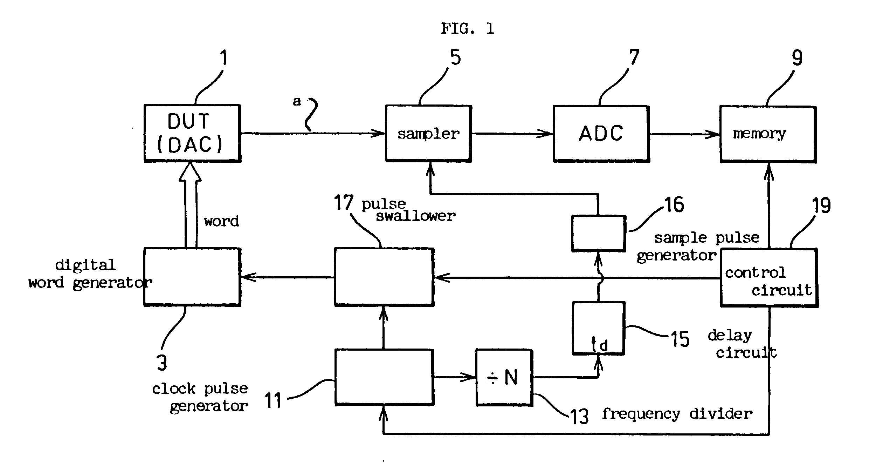

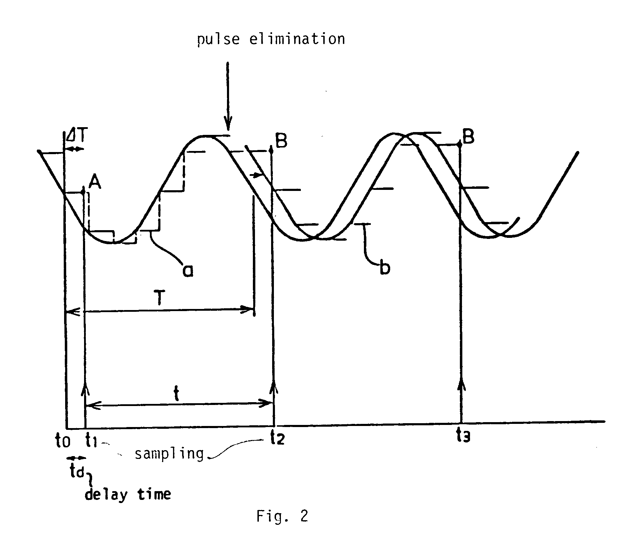

A preferred embodiment of a DAC measurement circuit of this invention is shown in Fig. 1. Fig. 2 explains the measurement operation of the measurement circuit shown in Fig. 1. A DAC 1 (having, for example, 8 bits or 16 bits of resolution) serving as a device under test receives data words from a digital word generator 3 and converts the data words to an analog signal, represented as "a" in Fig. 2. Digital word generator 3 generates data words representing a pseudo-sine wave having a period T. Signal a is converted into digital data by an analog-to-digital converter (ADC) 7 and the digital data is stored in a memory 9. A sample pulse generator 16, which is enabled by a clock pulse generator 11 via a frequency divider 13 (which may not be necessary in other embodiments) and a delay circuit 15, serves to actuate sampler 5. The delay time td of the delay circuit 15 is set for sampling to occur when the output signal of the DAC is stabilized. A pulse swallower 17 has the function of either passing output pulses from clock pulse generator 11 directly to digital word generator 3 or to eliminate a selected number of pulses from the stream of clock pulses running from clock pulse generator 11 to digital word generator 3. A typical example of the pulse swallower 17 is explained further in Japanese patent publication JP-A- 54-72657 assigned to Yokogawa-Hewlett-Packard Ltd. A control circuit 19 provides command signals to issue commands such as to store the output data of ADC 7 in memory 9 or to eliminate one or more pulses from the pulse stream entering pulse swallower 17, and concurrently controls the timing of the entire operation.

The procedure of operation of the measurement circuit shown in Fig. 1 is now described. First of all, if the pulse swallower 17 does not eliminate any pulse (or after a number of pulses has been eliminated), the signal a is generated by DAC 1 and sampling proceeds at t1, which is delayed from to by delay time td, and further samplings are carried out with period nT (n is an integer). Thus, the amplitude value of signal a at point A may be repeatedly measured so as to improve the accuracy of measurement of the output signal of ADC 7 by averaging multiple data for point A. The digital value corresponding to the amplitude value at this step of the DAC 1 output signal is then stored in a memory 9. Subsequently, the amplitude value of the output signal of DAC 1 at point B is measured. When the measurement at point A is completed, one pulse is eliminated (or, if a number of pulses had already been eliminated, one additional pulse is eliminated from the clock signal generated by clock signal generator 11) by pulse swallower 17. This will delay the time of generation of the next digital input word to DAC 1 by digital word generator 3 so that the output signal of DAC 1 becomes the signal b shown in Fig. 2. Sampler 5 accordingly now samples amplitude values corresponding to point B of the continuous signal b at t1, t2, t3, ... and an average of these values may be taken. Pulse swallower 17 successively eliminates additional pulses for sampling further steps of the output signal of DAC 1. In accordance with the present invention, the output signal of DAC 1 is delayed by using pulse swallower 17 instead of delaying the sampling time with a fixed delay time td, so that the amplitude value of each step of the DAC 1 output signal can be measured. In addition, if a highly accurate sampler is used for the sampler 5 as described in the embodiment above, a calculation for taking an average may not be necessary and thus measurement time can be shortened. The invention is an improved measurement circuit for evaluation of a DAC in that the output signal of the DAC 1 is delayed by pulse swallower 17 having a given (constant) minimal increment of delay time td for sampling, so that a programmable delay line is not necessary for this circuit. Because the delaying operation of such a pulse swallower can be accurately controlled in a simple manner, the amplitude value of the output signal at any desired sampling point can be measured in a succession of measurements while the DAC operates at a high rate of conversion. Furthermore, the location of any failure in the output signal of the DAC can be easily detected by monitoring the corresponding input words to the DAC.

**Claims**

1. Circuit for measuring characteristics of a digital to analog converter (DAC) (1) by measuring a periodic analog output signal produced by the DAC (1) in response to a sequence of digital input words suitable for a DAC (1) operating at a high converting rate comprising:

   clock pulse generating means (11);

   a digital word generator (3), triggered by the clock pulses, for providing a periodic sequence of digital input words to the DAC (1); and

   sampling means (5, 13, 15, 16), responsive to the clock pulses, for sampling the periodic analog output signal from the DAC (1) at a sampling point to produce sampled analog values;

   characterised in that
   - the sampling point has a constant delay time ($t_D$) with respect to the triggering time of the digital word generator (3), and
   - the circuit comprises pulse swallowing means (17), connected between the clock pulse generating means (11) and the digital word generator (3), for selectively eliminating clock pulses.

2. Circuit as in claim 1, characterized by:

   analog to digital converter means (ADC) (7) connected to the sampling means (5, 13, 15, 16), for reconverting the sampled analog values to digital values; and

   memory means (9) for storing the reconverted digital values.

3. Circuit as in claim 1 or 2, characterized in that

   the digital word generator (3) advances one digital word in the periodic sequence for each clock pulse, and

   the pulse swallowing means (17) eliminates one clock pulse to shift the sampling point from the analog output corresponding to one digital input word to the analog output corresponding to the next digital input word in the periodic sequence.

4. Circuit as in one of the claims 1 to 3, characterized in that

   the sampling means (5, 13, 15, 16) comprises:

   a sampler (5) triggered by sampling pulses to sample the amplitude of the analog output signal of the DAC (1);

   a frequency divider (13) responsive to the clock pulses by the clock pulse generating means (11) to produce a series of timing pulses having the frequency of the periodic sequence of digital input words;

   a delay circuit (15) responsive to the series of timing pulses to delay the pulses with respect to the clock pulses, by an interval ($t_D$) equal to the settling time of the DAC (1); and

   a sampling pulse generator (16) responsive to the delayed series of timing pulses, to produce the sampling pulses for triggering the sampler (5).

**Revendications**

1. Circuit de mesure pour l'évaluation d'un convertisseur numérique-analogique (CNA) par la mesure d'un signal de sortie analogique périodique engendré par le CNA (1) en réponse à une séquence de mots d'entrée numériques convenant pour un CNA (1) fonctionnant à grande vitesse de conversion, comprenant:

un moyen générateur d'impulsions d'horloge (11),

un générateur de mots numériques (3), déclenché par les impulsions d'horloge, destiné à fournir une séquence périodique de mots d'entrée numériques au CNA (1), et

un moyen de contrôle (5, 13,15, 16), réagissant aux impulsions d'horloge, destiné à contrôler le signal de sortie analogique périodique du CNA (1) en un point de contrôle, pour produire des valeurs analogiques contrôlées, caractérisé en ce que

- le point de contrôle a un temps de retard ($t_D$) constant par rapport au moment de déclenchement du générateur de mots numériques (3), et

- le circuit comprend un moyen d'avalement d'impulsions (17), connecté entre le moyen générateur d'impulsions d'horloge (11) et le générateur de mots numériques (3), destiné à éliminer sélectivement des impulsions d'horloge.

2. Circuit suivant la revendication 1, caractérisé par:

un moyen convertisseur analogique-numérique (CAN) (7) relié au moyen de contrôle (5, 13, 15, 16), destiné à reconvertir les valeurs analogiques contrôlées en valeurs numériques, et

un moyen de mémoire (9) destiné à la mémorisation des valeurs numériques reconverties.

3. Circuit suivant la revendication 1 ou 2, caractérisé en ce que le générateur de mots numériques(3) avance d'un mot numérique dans la séquence périodique pour chaque impulsion d'horloge, et

le moyen d'avalement d'impulsions (17) élimine une impulsion d'horloge pour décaler le point de contrôle de la sortie analogique correspondant à un mot d'entrée numérique à la sortie analogique correspondant au mot d'entrée numérique suivant dans la séquence périodique.

4. Circuit suivant l'une des revendications 1 à 3, caractérisé en ce que le moyen de contrôle (5, 13, 15, 16) comprend:

un contrôleur (5), déclenché par des impulsions de contrôle, destiné à contrôler l'amplitude du signal de sortie analogique du CNA (1),

un diviseur de fréquence (13), réagissant aux impulsions d'horloge par le moyen générateur d'impulsions d'horloge (11), destiné à engendrer une série d'impulsions de temporisation ayant la fréquence de la séquence périodique de mots d'entrée numériques,

un circuit de temporisaion (15), réagissant à la série d'impulsions de temporisation, destiné à retarder les impulsions par rapport aux impulsions d'horloge d'un intervalle ($t_D$) égal au temps de stabilisation du CNA (1), et

un générateur d'impulsions de contrôle (16), réagissant à la série retardée d'impulsions de temporisation, destiné à engendrer les impulsions de contrôle pour déclencher le contrôleur (5).

**Patentansprüche**

1. Schaltung zum Messen der Charakteristika eines Digital-Analog-Wandlers (DAW) (1) durch Messen eines periodischen analogen Ausgangssignals, welches durch den DAW (1) in Reaktion auf eine Sequenz von digitalen Eingangsworten erzeugt wird, welche für einen DAW (1) geeignet ist, der bei einer hohen Umwandlungsrate arbeitet, mit folgenden Merkmalen:

einer Taktpulserzeugungseinrichtung (11);

einem digitalen Wortgenerator (3), der durch die Taktpulse getriggert wird, um eine periodische Sequenz der digitalen Eingangsworte für den DAW (1) zu erzeugen; und

eine Abtasteinrichtung (5, 13, 15, 16), die auf die Taktpulse anspricht, um das periodische analoge Ausgangssignal von dem DAW (1) an einem Abtastpunkt abzutasten, um abgetastete analoge Werte zu erzeugen;

dadurch gekennzeichnet, daß

- der Abtastpunkt eine konstante Verzögerungszeit ($t_D$) bezüglich des Triggerzeitpunktes des digitalen Wortgenerators (3) hat, und

- daß die Schaltung eine Pulsschluckeinrichtung (17) aufweist, die zwischen der Taktpulserzeugungseinrichtung (11) und dem digitalen Wortgenerator (3) geschaltet ist, um selektiv Taktpulse zu eliminieren.

2. Schaltung nach Anspruch 1, gekennzeichnet durch

eine Analog-Digital-Wandlereinrichtung (ADW) (7), die an die Abtasteinrichtung (5, 13, 15, 16) angeschlossen ist, um die abgetasteten analogen Werte in digitale Werte rückumzuwandeln; und

eine Speichereinrichtung (9) zum Speichern der rückumgewandelten Digitalwerte.

3. Schaltung nach Anspruch 1 oder 2, dadurch gekennzeichnet, daß

   der digitale Wortgenerator (3) ein Digitalwort in der periodischen Sequenz für jeden Taktpuls vorschiebt, und

   die Pulsschluckeinrichtung (17) einen Taktpuls eliminiert, um den Abtastpunkt von dem Analogausgang entsprechend eines digitalen Eingangswortes zu dem Analogausgang entsprechend des nächsten digitalen Eingangswortes in der periodischen Sequenz zu verschieben.

4. Schaltung nach einem der Ansprüche 1 bis 3, dadurch gekennzeichnet, daß

   die Abtasteinrichtung (5, 13, 15, 16) folgende Merkmale aufweist:

   einen Abtaster (5), der durch Abtastpulse getriggert wird, um die Amplitude des analogen Ausgangssignals des DAW (1) abzutasten;

   einen Frequenzteiler (13), der auf die Taktpulse von der Taktpulserzeugungseinrichtung (11) anspricht, um eine Reihe von Zeitgabepulsen zu erzeugen, die die Frequenz der periodischen Sequenz der digitalen Eingangsworte haben;

   eine Verzögerungsschaltung (15), welche auf die Reihe von Zeitgabepulsen anspricht, um die Pulse bezüglich der Taktpulse um ein Intervall ($t_D$) zu verzögern, welches der Einstellzeit des DAW (1) gleicht; und

   einen Abtastpulsgenerator (16), der auf die verzögerte Reihe von Zeitgabepulsen anspricht, um die Abtastpulse zum Triggern des Abtasters (5) zu erzeugen.

FIG. 1

EP 0 191 478 B1

Fig. 2

FIG. 3

FIG. 4